(19) Europäisches Patentamt / European Patent Office / Office européen des brevets

(11) **EP 2 546 216 B1**

(12) **EUROPEAN PATENT SPECIFICATION**

(45) Date of publication and mention
of the grant of the patent:
**03.08.2016 Bulletin 2016/31**

(21) Application number: **11753404.0**

(22) Date of filing: **09.03.2011**

(51) Int Cl.:
***C04B 35/584*** $^{(2006.01)}$

(86) International application number:
**PCT/JP2011/055521**

(87) International publication number:
**WO 2011/111746 (15.09.2011 Gazette 2011/37)**

(54) **CERAMIC SINTERED COMPACT, CIRCUIT BOARD USING THE SAME, ELECTRONIC DEVICE AND THERMOELECTRIC CONVERSION MODULE**

GESINTERTER KERAMIKPRESSLING, LEITERPLATTE DAMIT, ELEKTRONISCHE VORRICHTUNG UND THERMOELEKTRISCHES UMWANDLUNGSMODUL

COMPRIMÉ FRITTÉ EN CÉRAMIQUE, CARTE DE CIRCUITS IMPRIMÉS L'UTILISANT, DISPOSITIF ÉLECTRONIQUE ET MODULE DE CONVERSION THERMOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.03.2010 JP 2010051760**

(43) Date of publication of application:
**16.01.2013 Bulletin 2013/03**

(73) Proprietor: **Kyocera Corporation**
**Kyoto 612-8501 (JP)**

(72) Inventors:
• **ISHIMINE,Yuusaku**
**Kirishima-shi**
**Kagoshima 899-4396 (JP)**
• **MORIYAMA,Masayuki**
**Kirishima-shi**
**Kagoshima 899-4312 (JP)**
• **KOMATSUBARA,Kenji**
**Kirishima-shi**
**Kagoshima 899-4396 (JP)**
• **NAKAO,Yuuya**
**Higashioumi-shi**
**Shiga 529-1595 (JP)**

(74) Representative: **TBK**
**Bavariaring 4-6**
**80336 München (DE)**

(56) References cited:
WO-A1-2008/114752     JP-A- 11 134 630
JP-A- 2002 203 993     JP-A- 2006 016 233
JP-A- 2007 258 298     JP-A- 2009 298 688

## Description

Technical field

The present invention relates to a ceramic sintered body for constituting a support substrate of a structural component such as a heat-dissipating member and a circuit member, as well as to a circuit board using the same, an electronic device, and a thermoelectric conversion module.

Background Art

In recent years there have been utilized electronic devices in which on a circuit member of a circuit board are mounted semiconductor devices including an insulated gate bipolar transistor (IGBT) element, a metal-oxide semiconductor field-effect transistor (MOSFET) element, a light-emitting diode (LED) element, a freewheeling diode (FWD) element, and a giant transistor (GTR) element, or various electronic components including a sublimation-type thermal printer head element, a thermal ink-jet printer head element, and a Peltier element. Moreover, in a radioisotope thermoelectric power generator, an exhaust heat recovery power generator, a photodetector which exploits Peltier-effect, cooling equipment for semiconductor manufacturing devices, equipment for adjustment of laser diode temperature and the like have been utilized thermoelectric conversion modules in which a thermal conversion element is sandwiched between the substrates. A ceramic sintered body is used for a support substrate of such a circuit board and thermoelectric conversion module, and high thermal conductivity is demanded of the ceramic sintered body.

For example, in Patent Literature 1, there is proposed, as an example of a ceramic sintered body having high thermal conductivity, sintered silicon nitride which contains a rare-earth metal in an amount of 2.0% to 17.5% by weight on an oxide basis, Mg in an amount of 0.3% to 3.0% by weight on an oxide basis, and impurities including Al, Li, Na, K, Fe, Ba, Mn, and B in a total amount of less than or equal to 0.3% by weight, and is composed of a silicon nitride crystal and a grain boundary phase, wherein the ratio of the crystalline compound phase in the grain boundary phase to the entire grain boundary phase is greater than or equal to 20%.

WO 2008/114752 A1 discloses an insert made of a sintered silicon nitride which comprises $\beta$-Si3N4 as the main component and contains Mg and rare earth elements Re (Y, La, Ce, Er, Dy, Yb) in amounts of 1.0 to 7.0% by mole in terms of MgO and 0.4 to 1.0% by mole in terms of oxide respectively with the total amount being 1.7% by mole or above and below 7.5% by mole. The insert has a gradient structure wherein the oxygen content increases from the surface toward the inside, namely, the oxygen content in the area of less than 0.5mm in depth is 0.8 to 1.5% by mass and that in the area of 0.5mm or above in depth is 1.1 to 2.3% by mass, with the oxygen content difference between both being 0.1 to 1.0% by mass.

JP 2009-298688 A is concerned with providing a low-loss, dense, dielectric material which has a low dielectric loss and high heat conductivity in a high-frequency region, a manufacturing method thereof, and a member thereof. To this end a low-loss, dense, dielectric material for high frequency is disclosed that comprises a silicon nitride sintered compact essentially comprising silicon nitride and comprising an alkaline earth metal compound, a group 3a compound in the periodic table and impurity oxygen, provided that the grain boundaries in the sintered compact are crystallized. The dielectric material has a dielectric loss of $\leq 5*10^{-4}$ and a thermal conductivity of $\geq 50$ W*m$^{-1}$*K$^{-1}$ in 2 GHz and 3 GHz and has a porosity of < 3%. The manufacturing method thereof and the member thereof are also disclosed. The dense dielectric material for high frequency which has high heat conductivity and low dielectric loss and the member thereof disclosed are used for an apparatus that generates plasma mainly by using high-frequency radiation such as microwave in an apparatus for manufacturing a semiconductor or a liquid crystal.

Citation List

Patent Literature

Patent Literature 1: Japanese Unexamined Patent Publication JP-A 2000-34172

Summary of Invention

Technical Problem

However, sintered silicon nitride poses the problem that the presence of rare-earth oxide in the grain boundary phase precludes adequate enhancement in rigidity with a consequent possibility of warpage.

The invention has been devised to solve the problem as mentioned supra, and accordingly an object of the invention is to provide a ceramic sintered body which excels in thermal conductivity and exhibits high rigidity even in the presence of rare-earth oxide in its grain boundary phase, a circuit board using the same, an electronic device, and a thermoelectric conversion module.

Solution to Problem

The above problems are solved by the subject-matter of the independent claims.

Advantageous Effects of Invention

According to the invention, the ceramic sintered body includes the main crystalline phase predominantly composed of silicon nitride, and the grain boundary phase predominantly composed of magnesium oxide and rare-earth oxide, the grain boundary phase containing components which are expressed in compositional formula form as: $REMgSi_2O_5N$, $RE_2Si_3O_3N_4$, and $RE_4Si_2O_7N$, respectively, where RE represents rare-earth metal which is Er, Yb or Y and where the grain boundary phase has a magnesium oxide content of greater than or equal to 1.3% by mass and less than or equal to 5% by mass, and has a rare-earth oxide content of greater than or equal to 10% by mass and less than or equal to 17% by mass. Accordingly, it is possible to obtain a ceramic sintered body which excels in thermal conductivity and exhibits high rigidity.

Moreover, according to the invention, the circuit board includes the support substrate made of the ceramic sintered body of the invention, the circuit member mounted on the first main surface of the support substrate, and the heat-dissipation member mounted on the second main surface of the support substrate opposite from the first main surface. With use of the support substrate made of the ceramic sintered body which excels in thermal conductivity and exhibits high rigidity, the circuit board is resistant to cracking which occurs in the support substrate, and can thus be made with high reliability.

Further, according to the invention, the electronic device includes the circuit board of the invention, and the electronic component mounted on the circuit member of the circuit board. Accordingly, the electronic device can be made with high reliability.

Still further, according to the invention, the thermoelectric conversion module includes the support substrate formed of the ceramic sintered body of the invention, and the thermoelectric conversion device composed of the p-type thermoelectric conversion element and the n-type thermoelectric conversion element, the thermoelectric conversion element being electrically connected and bonded to the support substrate. Accordingly, the thermoelectric conversion module is resistant to cracking which occurs in the support substrate, and can thus be made with high reliability.

Brief Description of Drawings

Fig. 1 shows an example of a circuit board according to an embodiment, and Fig. 1(a) is a plan view thereof, Fig. 1(b) is a sectional view thereof taken along the line A-A' of Fig. 1(a), and Fig. 1(c) is a bottom view thereof;
Fig. 2 shows another example of the circuit board according to the embodiment, and Fig. 2(a) is a plan view thereof, Fig. 2(b) is a sectional view thereof taken along the line B-B' of Fig. 2(a), and Fig. 2(c) is a bottom view thereof;
Fig. 3 shows still another example of the circuit board according to the embodiment, and Fig. 3(a) is a plan view thereof, Fig. 3(b) is a sectional view thereof taken along the line C-C' of Fig. 3(a), and Fig. 3(c) is a bottom view thereof;
Fig. 4 shows an example of an electronic device according to an embodiment, and Fig. 4 (a) is a plan view thereof, Fig. 4(b) is a sectional view thereof taken along the line D-D' of Fig. 4(a), and Fig. 4(c) is a bottom view thereof; and
Fig. 5 shows an example of a thermoelectric conversion module according to an embodiment, and Fig. 5(a) is a perspective view, partially broken away, of the module, and Fig. 5(b) is a sectional view thereof.

Description of Embodiments

A ceramic sintered body in accordance with an embodiment includes a main crystalline phase predominantly composed of silicon nitride, and a grain boundary phase predominantly composed of magnesium oxide and rare-earth oxide, the grain boundary phase containing a component which is expressed in compositional formula form as: $REMgSi_2O_5N$, where RE represents rare-earth metal. In the case where the component represented as $REMgSi_2O_5N$ is included in the grain boundary phase, the content of a readily-deformable amorphous phase of the grain boundary phase becomes relatively small. This makes it possible to suppress deformation of the grain boundary phase, and thereby achieve an increase in rigidity. Moreover, although the amorphous phase is prone to deformation especially when it is subjected to high temperature, in the ceramic sintered body of the embodiment, since the content of the amorphous phase is relatively small, it is possible to suppress deformation under high-temperature conditions more reliably. Further, by virtue of the excellence in thermal conductivity of $REMgSi_2O_5N$, the ceramic sintered body tends to have an even higher thermal conductivity.

In the ceramic sintered body of the embodiment, the main crystalline phase has a silicon nitride content of greater than or equal to 80% by mass as a major constituent. In particular, where the content of silicon nitride is greater than or equal to 90% by mass, the ceramic sintered body tends to have higher heat-dissipation capability and higher mechanical strength as is desirable. As used in the embodiment, the term "main crystalline phase" refers to, of two or more crystalline phases, the crystalline phase having the largest mass ratio.

Silicon nitride contained in the main crystalline phase of the ceramic sintered body can be identified by X-ray diffractometry. Moreover, the amounts of components included in the crystalline phase or the grain boundary phase can be measured by conducting EDS (Energy Dispersive Spectroscopy) analysis on any given part of the phase using EPMA or TEM. For example, the identification of silicon nitride contained in the main crystalline phase can be made by determining the content of silicon (Si) and subsequently converting the silicon content into its equivalent in silicon-nitride ($Si_3N_4$) form. Moreover, the content of silicon nitride in the ceramic sintered body can be determined by obtaining the content of silicon by means of fluorescent X-ray analysis or ICP (Inductively Coupled Plasma) emission spectrometry and subsequently converting the silicon content into its equivalent in silicon-nitride form. The amount of silicon nitride contained in the ceramic sintered body of the embodiment is greater than or equal to 80% by mass, or preferably greater than or equal to 90% by mass.

The grain boundary phase of the ceramic sintered body of the embodiment is predominantly composed of magnesium oxide (MgO) and rare-earth oxide (for example, at least one of $Sc_2O_3$, $Y_2O_3$, $La_2O_3$, $Ce_2O_3$, $Pr_6O_{11}$, $Nd_2O_3$, $Pm_2O_3$, $SM_2O_3$, $Eu_2O_3$, $Gd_2O_3$, $Tb_2O_3$, $Dy_2O_3$, $HO_2O_3$, $Er_2O_3$, $Tm_2O_3$, $Yb_2O_3$, and $Lu_2O_3$) and contains a component which is expressed in compositional formula form as: $REMgSi_2O_5N$ (RE represents rare-earth metal). The rare-earth metal (RE) constituting the component represented as $REMgSi_2O_5N$ is Er, Yb or Y. In further examples useful for understanding the invention the rare-earth metal is another lanthanoid metal (La, Ce, Pr, Nd, Pm, Sm, Eu, Gd, Tb, Dy, Ho, Tm, Lu). This is because, of the Group 3 elements in the periodic table, erbium and ytterbium have a smaller ionic radius and can therefore be bound firmly to other atoms forming the above compositional formula, namely Si, O, and N, with consequent good phonon transmission. This leads to enhancement in thermal conductivity. In addition to that, erbium and ytterbium being bound firmly to Si, O, and N, undergo little lattice vibration under heat energy, and its volumetric expansion resulting from temperature changes is so small that the coefficient of thermal expansion can be decreased. This leads to enhancement in thermal shock-resistant characteristics. By selecting at least one of erbium, and ytterbium as the rare-earth metal (RE) constituting the component, it is possible to create a tendency that, for example, the thermal expansion coefficient at ambient temperature decreases further to $2.35 \times 10^{-6}$/K or less, and also the thermal conductivity increases to 55 W/(m·K) or more.

Moreover, the use of erbium (Er) as the rare-earth metal (RE) constituting the component is more desirable. This is because the oxidative product of Er, namely erbium oxide ($Er_2O_3$) is relatively inexpensive, and also sintering process can be carried out at a lower temperature than would be the case of adding ytterbium oxide ($Yb_2O_3$).

The magnesium oxide, the rare-earth oxide, and the component expressed in compositional formula form as: $REMgSi_2O_5N$ (RE represents rare-earth metal) thus far described can be identified by X-ray diffractometry.

Moreover, the content of each of the magnesium oxide, the rare-earth oxide, and the component expressed in compositional formula form as: $REMgSi_2O_5N$ (RE represents rare-earth metal) can be determined by energy dispersive X-ray spectrometry. Note that the magnesium oxide and the rare-earth oxide can be defined as major constituents of the grain boundary phase in so far as they are contained in a larger amount than other components contained in the grain boundary phase, and the total amount of the magnesium oxide and the rare-earth oxide exceeds 50% by mass with respect to the total amount of the constituents of the grain boundary phase on an oxide basis. In the case where the grain boundary phase includes the magnesium oxide and the rare-earth oxide as major constituents, in addition to being able to increase the mechanical strength, oxygen contained in the main crystalline phase can be readily taken into the grain boundary phase, with a consequent tendency of improvement in heat-dissipation characteristics as is desirable. Moreover, in the case where the magnesium oxide and the rare-earth oxide are included in the grain boundary phase so that their total amount is greater than or equal to 60% by mass with respect to the total amount of the constituents of the grain boundary phase on an oxide basis, further improvement in mechanical characteristics and heat-dissipation characteristics can be achieved as is more desirable.

Moreover, in order to improve the heat-dissipation characteristics of the ceramic sintered body of the embodiment, it is desirable to reduce the amount of oxygen contained in the main crystalline phase, and more specifically lessen oxygen contained in silicon nitride powder during firing process. Note that "oxygen contained in silicon nitride powder" means oxygen adsorbed on the surfaces of silicon nitride powder during e.g., powder production process.

Further, in the ceramic sintered body of the embodiment, a half width of the peak of intensity ($I_1$) in the component expressed in compositional formula form as: $REMgSi_2O_5N$ (RE represents rare-earth metal) at the angle of diffraction in a range of 30 to 31°, which is determined by X-ray diffractometry, is preferably less than or equal to 0.4°.

In the case where the half width of the peak intensity $I_1$ at the diffraction angle of 30 to 31° in the component expressed in compositional formula form as: $REMgSi_2O_5N$ (RE represents rare-earth metal) is less than or equal to 0.4°, there arises a tendency that crystal distortion occurring in $REMgSi_2O_5N$ (RE represents rare-earth metal) are reduced, and the ceramic sintered body exhibits even higher thermal conductivity and rigidity. It is advisable that the half width is derived in the form of a diffraction angle which corresponds to a peak width at the position of one-half (I/2) of the height of a peak intensity (I) in the crystal structure as indicated by an X-ray diffraction chart.

Moreover, in the ceramic sintered body of the embodiment, it is preferable that the ratio between $I_1$ and $I_0$ ($I_1/I_0$) is greater than or equal to 5.5%, where $I_0$ denotes the intensity of a peak in silicon nitride included in the main crystalline phase at the angle of diffraction of 27 to 28° that is determined by X-ray diffractometry.

Under the condition where the peak intensity at the diffraction angle of 27 to 28° in silicon nitride included in the main crystalline phase is $I_0$, when the ratio ($I_1/I_0$) is greater than or equal to 5.5%, the size distribution of the crystalline lattice constituting the component represented as $REMgSi_2O_5N$ (RE represents rare-earth metal), as well as the distribution of planar lattice displacement, tends to become narrower, with a consequent tendency that the ceramic sintered body exhibits even higher thermal conductivity and rigidity.

Moreover, in the ceramic sintered body of the embodiment, the grain boundary phase includes, in addition to the component represented as $REMgSi_2O_5N$ (RE represents rare-earth metal), at least one of components that are expressed in compositional formula form as: $RE_2Si_3O_3N_4$ and $RE_4Si_2O_7N_2$, respectively. Further examples useful for understanding the invention include also $RE_5Si_3O_{12}N$ (RE represents rare-earth metal). By adding at least one of the components expressed in compositional formula form as: $RE_2Si_3O_3N_4$, $RE_4Si_2O_7N_2$, and $RE_5Si_3O_{12}N$ (RE represents rare-earth metal), respectively, to the grain boundary phase, it is possible to render the content of the readily-deformable amorphous phase relatively small, and thereby create a tendency of further increase of the rigidity. Further, the components expressed in compositional formula form as: $RE_2Si_3O_3N_4$, $RE_QSi_2O_7N_2$, and $RE_5Si_3O_{12}N$ (RE represents rare-earth metal), respectively, are higher in thermal conductivity than the amorphous phase, wherefore the ceramic sintered body tends to exhibit even higher thermal conductivity.

It is advisable that the rare-earth metal (RE) constituting each of the components expressed in compositional formula form as: $RE_2Si_3O_3N_4$, $RE_4Si_2O_7N_2$, and $RE_5Si_3O_{12}N$ (RE represents rare-earth metal), respectively, is the same as that constitutes the component represented as $REMgSi_2O_5N$ (RE represents rare-earth metal).

It is noted that the grain boundary phase may include, in addition to the magnesium oxide, the rare-earth oxide, and the components expressed in compositional formula form as: $REMgSi_2O_5N$, $RE_2Si_3O_3N_4$, $RE_4Si_2O_7N_2$, and $RE_5Si_3O_{12}N$, respectively (RE represents rare-earth metal) thus far described, silicon oxide, oxidative products of inevitable impurities contained in the raw materials such for example as iron oxide or calcium oxide, and the like.

Moreover, in the ceramic sintered body of the embodiment, it is preferable that the product of relative permittivity and dielectric loss tangent (dielectric dissipation factor) at any given frequency in the range of 2 GHz to 3 GHz is less than or equal to 0.01 (exclusive of 0).

When an alternating voltage is applied in a high-frequency region by using the ceramic sintered body, even if a microwave propagates through the interior of the ceramic sintered body, so long as the product of permittivity and dielectric loss tangent is small, the microwave is less prone to attenuation. Therefore, in the case where the product of relative permittivity and dielectric loss tangent at any given frequency in the range of 2 GHz to 3 GHz is less than or equal to 0.01 (exclusive of 0), the ceramic sintered body can be desirably used as a member which is required to have high microwave transmission characteristics, for example, a microwave transmission window member of plasma treatment equipment, and is also applicable to various structural components mounted inside plasma treatment equipment or substrates for signal transfer in a microwave region.

It is noted that the values of relative permittivity and dielectric loss tangent can be obtained by a commonly-used measurement method in conformity with JIS R 1627-1996, for example.

The mechanical characteristics of the ceramic sintered body of the embodiment preferably involve a three-point bending strength of greater than or equal to 750 MPa; a dynamic elasticity modulus of greater than or equal to 300 GPa; a Vickers hardness (Hv) of greater than or equal to 13 GPa; and a fracture toughness ($K_{1c}$) of greater than or equal to 5 MPam$^{1/2}$. In the case where the values of such mechanical characteristics fall within the above prescribed ranges, a connection member formed by bonding the ceramic sintered body of the embodiment and a metal-made member together tends to have improved creep resistance and heat cycle endurance, and can therefore be used for a longer period of time with higher reliability.

It is noted that the three-point bending strength can be measured in conformity with JIS R 1601-2008 (ISO 17565: 2003 (MOD)). However, if the ceramic sintered body is so thin that a test piece obtained by cutting the ceramic sintered body cannot be made to have a thickness of 3 mm, the thickness of the ceramic sintered body in itself will be evaluated as the thickness of the test piece. It is preferable that, also in this case, the measurement value satisfies the above prescribed condition.

Moreover, an evaluation of the rigidity of the ceramic sintered body can be conducted on the basis of dynamic elasticity modulus. The dynamic elasticity modulus can be measured in conformity with JIS R 1602-1995-defined ultrasonic pulse method. However, if the ceramic sintered body is so thin that a test piece obtained by cutting the ceramic sintered body cannot be made to have a thickness of 10 mm, evaluation will be conducted by the cantilever-based resonance method. It is preferable that, also in this case, the measurement value satisfies the above prescribed condition.

The Vickers hardness (Hv) and the fracture toughness ($K_{1c}$) can be measured in conformity with JIS R 1610-2003 (ISO 14705: 2000 (MOD)) and the indentation fracture method (IF method) defined by JIS R 1607-1995, respectively. If the ceramic sintered body is so thin that test pieces obtained by cutting the ceramic sintered body cannot be made to have a thickness of 0.5 mm and a thickness of 3 mm as prescribed in JIS R 1610-2003 and the indentation fracture method (IF method) according to JIS R 1607-1995, respectively, the thickness of the ceramic sintered body in itself will be evaluated as the thickness of the test piece. It is preferable that, also in this case, the measurement value satisfies the above prescribed condition. However, if the ceramic sintered body in itself has too small a thickness and the result of evaluation shows that the above prescribed condition cannot be fulfilled, for example, if the thickness is equal to or greater than 0.2 mm but less than 0.5 mm, the Vickers hardness (Hv) and the fracture toughness ($K_{1c}$) can be measured under conditions where an experimental force and a load of indentation to be applied to the ceramic sintered body are each set at 0.245 N, and the time to retain the experimental force and the time to retain the indentation load are each set at 15 seconds.

Moreover, the electrical characteristics of the ceramic sintered body as above described preferably involve a volume resistivity which is greater than or equal to $10^{14}$ $\Omega$·cm at ambient temperature, yet is greater than or equal to $10^{12}$ $\Omega$·cm at a temperature of 300°C. The volume resistivity can be measured in conformity with JIS C 2141-1992. However, if the ceramic sintered body is too small to exhibit a volume resistivity as prescribed in JIS C 2141-1992, evaluation will be conducted by the two-terminal method. It is preferable that, also in this case, the measurement value satisfies the above prescribed condition.

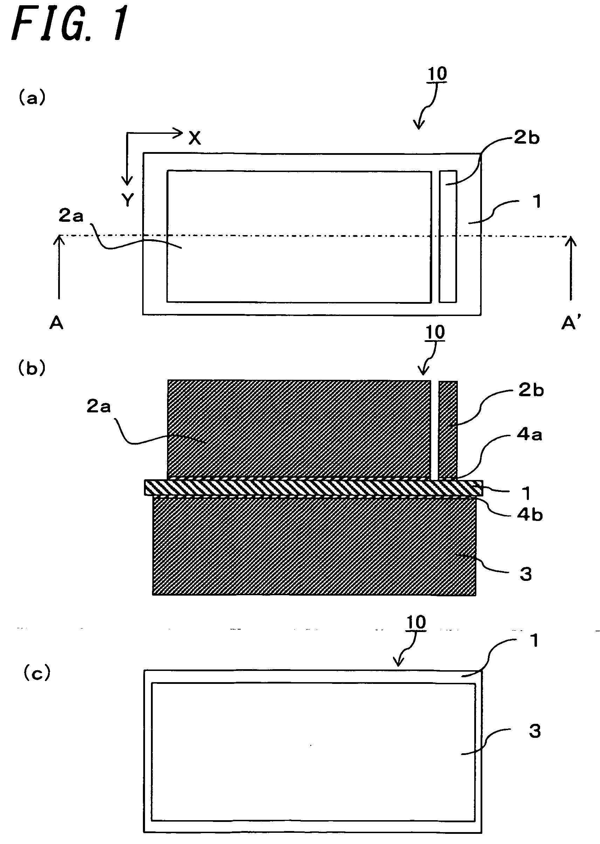

Fig. 1 shows an example of a circuit board according to the embodiment, and Fig. 1(a) is a plan view thereof, Fig. 1(b) is a sectional view thereof taken along the line A-A' of Fig. 1(a), and Fig. 1(c) is a bottom view thereof.

A circuit board 10 as exemplified in Fig. 1 includes a support substrate formed of the ceramic sintered body of the embodiment, a circuit member 2 mounted on a first main surface of the support substrate 1, and a heat-dissipation member 3 mounted on a second main surface of the support substrate 1 opposite from the first main surface.

From the use of the support substrate 1 made of the ceramic sintered body of the embodiment capable of provision of high rigidity, it can be judged that the thusly constructed circuit board 10 is designed for high reliability.

In the circuit board 10 exemplified in Fig. 1, two circuit members 2a and 2b are bonded to the first main surface of the support substrate 1, with a brazing material 4a interposed between them, and the heat-dissipation member 3 is bonded to the second main surface thereof, with a brazing material 4b interposed between them.

The support substrate 1, which is formed of ceramic sintered body, constituting the circuit board 10 of the present example has the form of a flat plate and, for example, falls in the range of 20 mm or more and 200 mm or less in length (corresponding to an X direction in Fig. 1) and falls in the range of 10 mm or more and 120 mm or less in width (corresponding to a Y direction in Fig. 1). Although the thickness of the support substrate 1 varies according to its application, in the interest of high durability, high dielectric strength, and inhibition of thermal resistance, it is preferable that the thickness of the support substrate 1 falls in the range of 0.2 mm or more and 1.0 mm or less.

Moreover, the circuit member 2a constituting the circuit board 10 of the example falls in the range of 15 mm or more and 155 mm or less in length (corresponding to the X direction in Fig. 1) and falls in the range of 8 mm or more and 100 mm or less in width (corresponding to the Y direction in Fig. 1), for example. The circuit member 2b falls in the range of 1 mm or more and 10 mm or less in length (corresponding to the X direction in Fig. 1) and falls in the range of 8 mm or more and 100 mm or less in width (corresponding to the Y direction in Fig. 1), for example. The thickness of the circuit member 2a, 2b is determined in consideration of the magnitude of electric current which passes through the circuit member 2a, 2b, the amount of heat liberated by an electronic component (not shown) mounted on the circuit member 2a, 2b, and so forth. For example, the thickness falls in the range of 0.5 mm or more and 5 mm or less.

Moreover, the heat-dissipation member 3 constituting the circuit board 10 has the capability of allowing the heat liberated by the electronic component (not shown) to escape. For example, the heat-dissipation member 3 falls in the range of 18 mm or more and 190 mm or less in length (corresponding to the X direction in Fig. 1), falls in the range of 8 mm or more and 100 mm or less in width (corresponding to the Y direction in Fig. 1), and falls in the range of 0.5 mm or more and 5 mm or less in thickness.

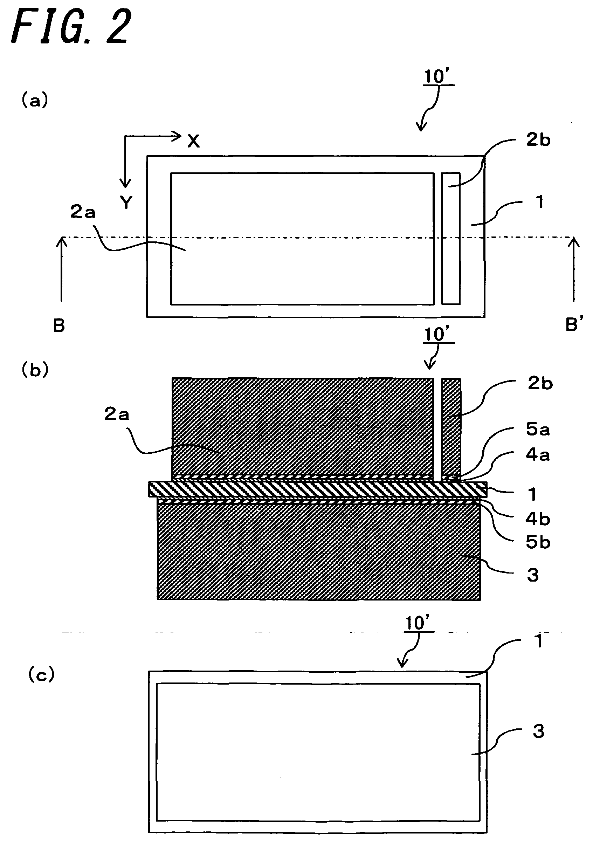

Fig. 2 shows another example of the circuit board according to the embodiment, and Fig. 2(a) is a plan view thereof, Fig. 2(b) is a sectional view thereof taken along the line B-B' of Fig. 2(a), and Fig. 2(c) is a bottom view thereof.

In a circuit board 10' as exemplified in Fig. 2, the circuit member 2a, 2b and the heat-dissipation member 3 adopted in the circuit board 10 exemplified in Fig. 1 are bonded to the support substrate 1 through the brazing material 4a as well as a copper material 5a and the brazing material 4b as well as a copper material 5b, respectively. The circuit board 10' exemplified in Fig. 2 affords the same effects as achieved in the circuit board 10 exemplified in Fig. 1. Moreover, in contrast to the circuit board 10 exemplified in Fig. 1 in which the bonding process is conducted at a temperature in a range of 800 to 900°C, in the circuit board 10', with the interposition of the copper materials 5a and 5b, the circuit member 2a, 2b and the copper material 5a, as well as the heat-dissipation member 3 and the copper material 5b, can be bonded to each other in a condition where their constituent copper elements are diffused at a relatively low temperature in a range of ca. 300 to 500°C. Therefore, occurrence of warpage in the support substrate 1 can be suppressed. In consequence, the stress applied to the support substrate 1 is so small that the support substrate 1 becomes less prone to cracking even under repeated heat application. Further, at least one of the circuit member 2a, 2b and the heat-dissipation member 3 can be thickened, with a consequent tendency of improvement in heat-dissipation characteristics.

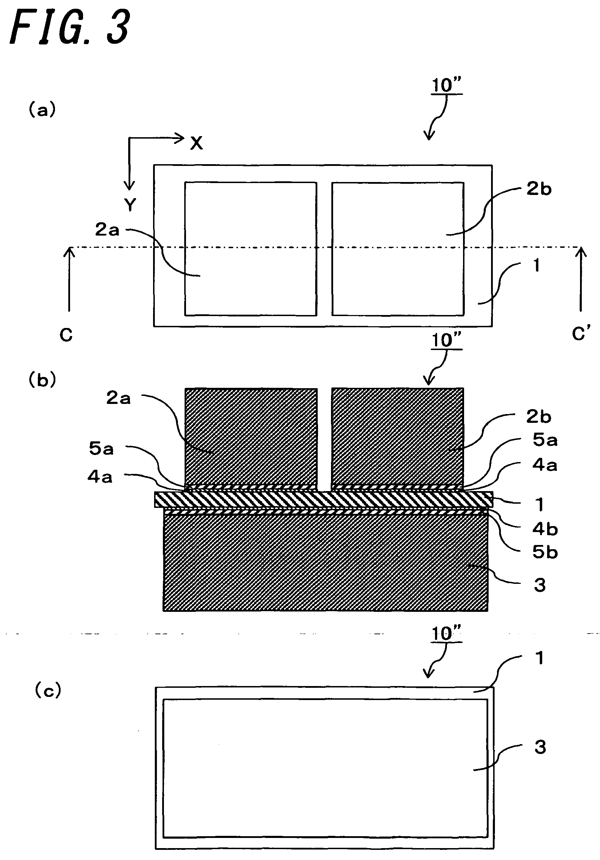

Fig. 3 shows still another example of the circuit board according to the embodiment, and Fig. 3(a) is a plan view thereof, Fig. 3(b) is a sectional view thereof taken along the line C-C' of Fig. 3(a), and Fig. 3(c) is a bottom view thereof.

A circuit board 10" as exemplified in Fig. 3 has basically the same structure as the circuit board 10' shown in Fig. 2, and the only difference is that, in the former, the circuit members 2a and 2b have the same size. For example, the dimensions of the circuit member 2a, 2b, namely its length (corresponding to the X direction in Fig. 1), width (corresponding to the Y direction in Fig. 1), and thickness fall in the range of 8 mm or more and 100 mm or less, fall in the range of 8 mm or more and 100 mm or less, and fall in the range of 0.5 mm or more and 5 mm or less, respectively.

As with the example shown in Fig. 3, in the case where the circuit members 2a and 2b having the same size are arranged on the first main surface of the support substrate 1, in contrast to the circuit board 10' as exemplified in Fig. 2, the same-size circuit members 2a and 2b are bonded to each other. This makes it possible to avoid unevenness in stress development in the support substrate 1, and thereby suppress occurrence of warpage in the support substrate 1 more reliably.

It is preferable that the circuit member 2a, 2b and the heat-dissipation member 3 have a copper content of greater than or equal to 90% by mass. Specifically, the circuit member 2a, 2b and the heat-dissipation member 3 are preferably made of one of oxygen-free copper, tough pitch copper, and phosphorous-deoxidized copper. In particular, of oxygen-free copper, the use of one of linear-crystal oxygen-free copper, high-purity single-crystal oxygen-free copper, and vacuum-melted copper that have a copper content of 99.995% or more by mass is desirable. Thus, with a high content of copper, each of the circuit member 2a, 2b and the heat-dissipation member 3 exhibits low electric resistance and high thermal conductivity, with a consequent improvement in heat-dissipation characteristics. In the circuit member 2a, 2b in particular, circuit characteristics (the special property of being able to suppress heat generation from the electronic component mounted on the circuit member 2a, 2b for reduction in power loss) can be improved. Moreover, with a high content of copper, the level of yield stress is lowered, wherefore ductile deformation tends to take place under application of heat. As a result, the adhesion between the circuit member 2a, 2b and the copper material 5a and the adhesion between the heat-dissipation member 3 and the copper material 5b can be increased, with a consequent higher reliability.

Moreover, it is preferable that the brazing material 4a, 4b is predominantly composed of at least one of silver and copper, and contains one or more of substances selected from among titanium, zirconium, hafnium, and niobium. The thickness of the brazing material 4a, 4b falls in the range of 5 $\mu$m or more and 20 $\mu$m or less, for example.

Moreover, the copper material 5a, 5b is preferably made of one of oxygen-free copper, tough pitch copper, and phosphorous-deoxidized copper. In particular, of oxygen-free copper, the use of one of linear-crystal oxygen-free copper, high-purity single-crystal oxygen-free copper, and vacuum-melted copper that have a copper content of 99.995% or more by mass is desirable. The thickness of the copper material 5a, 5b falls in the range of 0.1 mm or more and 0.6 mm or less, for example.

It is noted that the three-point bending strength, the dynamic elasticity modulus, the Vickers hardness (Hv), and the fracture toughness ($K_{1c}$) of the support substrate 1, which is formed of the ceramic sintered body, constituting the circuit board can be determined by the above-described methods after removing the brazing materials 4a and 4b and the copper materials 5a and 5b from the circuit board.

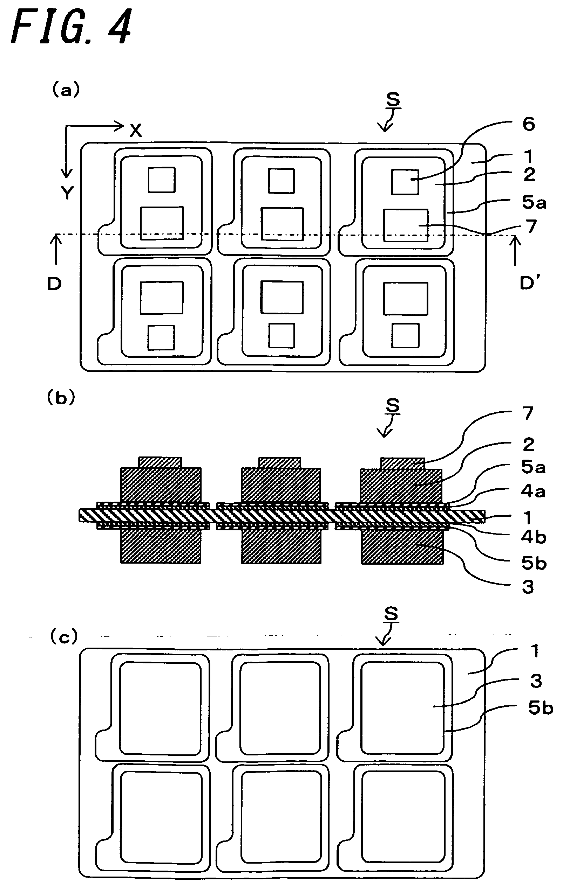

Fig. 4 shows an example of an electronic device according to an embodiment, and Fig. 4(a) is a plan view thereof, Fig. 4(b) is a sectional view thereof taken along the line D-D' of Fig. 4(a), and Fig. 4(c) is a bottom view thereof.

An electronic device S as exemplified in Fig. 4 includes the circuit board 10 of the embodiment, and one or more electronic components 6, 7 such as a semiconductor device on the circuit member 2 of the circuit board 10. The electronic components 6 and 7 are electrically connected to each other by a conductor (not represented graphically). According to the electronic device S of the embodiment, since the electronic components 6 and 7 are mounted on the circuit member 2 of the circuit board 10 of the embodiment, even if the electronic components 6 and 7 generate heat repeatedly, the support substrate 1 and the circuit member 2 as well as the heat-dissipation member 3 will not be easily detached from each other. This makes it possible to render the electronic device highly durable.

For example, the dimensions of the support substrate 1 exemplified in Fig. 4, namely its length (corresponding to the X direction in Fig. 1), width (corresponding to the Y direction in Fig. 1), and thickness preferably fall in the range of 20 mm or more and 200 mm or less, fall in the range of 10 mm or more and 120 mm or less, and fall in the range of 0.2 mm or more and 1.0 mm or less, respectively. Moreover, the dimensions of each of the circuit member 2 and the heat-dissipation member 3, namely its length (corresponding to the X direction in Fig. 1), width (corresponding to the Y direction in Fig. 1), and thickness preferably fall in the range of 4 mm or more and 40 mm or less, fall in the range of 5 mm or more and 50 mm or less, and fall in the range of 0.5 mm or more and 5 mm or less, respectively.

Moreover, as with the example shown in Fig. 4, it is preferable that the circuit members 2, as well as the heat-dissipation members 3, are arranged in a plurality of rows and columns as viewed in a plan view. By arranging the circuit members 2 and the heat-dissipation members 3 in a plurality of rows and columns as viewed in a plan view, it is possible to allow a stress, which is applied to the support substrate 1 when the circuit member 2 and the heat-dissipation member 3 are bonded to the support substrate 1, to disperse readily, and thereby suppress warpage of the support substrate 1 more reliably.

Specifically, as with the example shown in Fig. 4, it is preferable that the circuit members 2, as well as the heat-dissipation members 3, are equidistantly arranged in a plurality of rows and columns as viewed in a plan view.

According to the circuit board 10 and the electronic device S exemplified in Figs. 1 to 4, since the support substrate 1 is resistant to warpage, it follows that cracking is less likely to occur even under repeated heat application. This makes it possible to obtain highly-reliable circuit board and electronic device.

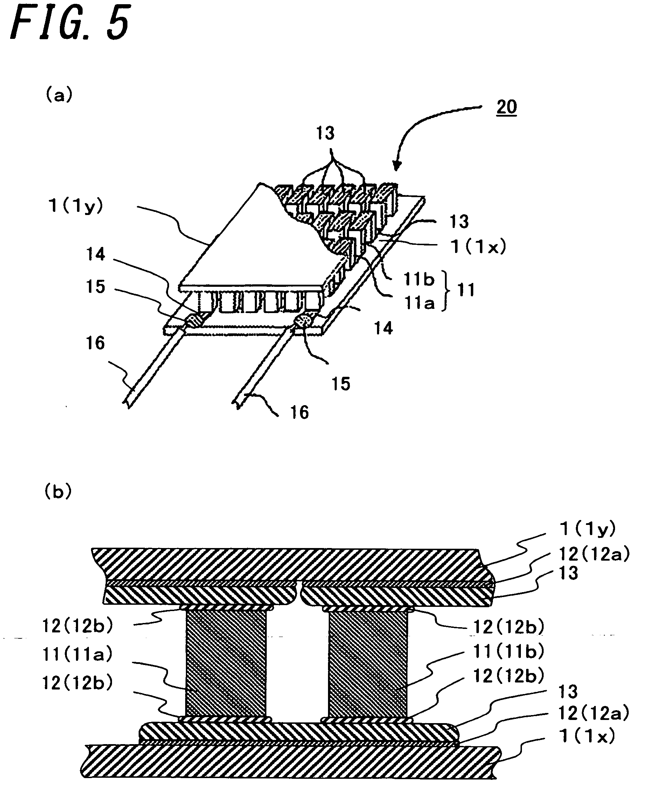

Fig. 5 shows an example of a thermoelectric conversion module according to an embodiment, and Fig. 5(a) is a perspective view, partially broken away, of the module, and Fig. 5(b) is a sectional view thereof.

A thermoelectric conversion module 20 as shown in Fig. 5 includes the support substrates 1x and 1y each formed of the ceramic sintered body of the embodiment, and thermoelectric conversion devices 11 each composed of a p-type thermoelectric conversion element 11a and an n-type thermoelectric conversion element 11b, the thermoelectric conversion devices 11 being electrically connected and bonded between the support substrates 1x and 1y.

In the thermoelectric conversion module 20 shown in Fig. 5, the thermoelectric conversion devices 11 are each bonded to the support substrate 1 through a bonding layer 12 (12a), a wiring conductor 13, and a second bonding layer 12 (12b) arranged in the order presented in the direction from the support substrate 1. Moreover, in the array of the thermoelectric conversion devices 11 placed between the support substrates 1x and 1y, the thermoelectric conversion devices 11 acting as a beginning end and a terminal end, respectively, of an electric circuit are each connected to an external connection terminal 14. The external connection terminal 14 is connected with a lead wire 16 by solder 15 for external supply of electric power.

The use of the ceramic sintered body of the embodiment for such a support substrate 1x, 1y makes it possible to obtain a highly-reliable thermal conduction module 20 which is resistant to cracking even under repeated heat application. Note that, in the thermoelectric conversion module 20 of the embodiment, it is essential only that one of the support substrates 1x and 1y be made of the ceramic sintered body of the embodiment, and therefore the other one of them may be made of ceramic sintered body different from the ceramic sintered body of the embodiment, or may be a support substrate made of resin or metal.

Next, a method for manufacturing the ceramic sintered body of the embodiment will be described.

To begin with, powder of silicon nitride, the β-phase transition rate of which is less than or equal to 20%, and, as additive components, powder of magnesium oxide (MgO) and rare-earth oxide (at least one of $Y_2O_3$, $Er_2O_3$, $Yb_2O_3$; according to further examples useful for understanding the invention $Sc_2O_3$, $La_2O_3$, $Ce_2O_3$, $Pr_6O_{11}$, $Nd_2O_3$, $Pm_2O_3$, $Sm_2O_3$, $Eu_2O_3$, $Gd_2O_3$, $Tb_2O_3$, $Dy_2O_3$, $Ho_2O_3$, $Tm_2O_3$, and $Lu_2O_3$ are used) are mixed together with water by wet mixing using any given mill such for example as a barrel mill, a tumbling mill, a vibrating mill, a bead mill, a sand mill, or an agitator mill. The resultant mixture is pulverized to form a slurry.

It is noted that silicon nitride is classified into two categories, namely α type and β type, based on crystalline structure. Silicon nitride of α type is stable under low-temperature conditions, whereas silicon nitride of β type is stable under high-temperature conditions. At a temperature of 1400°C or above, an irreversible α-to-β phase transition will take place. As used herein, the term "β-phase transition rate" refers to a value obtained by calculation according to the following formula:

β-phase transition rate = $\{I_\beta/(I_\alpha + I_\beta)\} \times 100$ (%) wherein $I_\alpha$ represents the sum of the peak intensity of an α (102) diffraction line and that of an α (210) diffraction line obtained by X-ray diffractometry, and $I_\beta$ represents the sum of the peak intensity of a β (101) diffraction line and that of a β (210) diffraction line obtained by X-ray diffractometry.

The β-phase transition rate of silicon nitride powder exerts an influence upon the strength and the value of fracture toughness of the ceramic sintered body predominantly composed of silicon nitride. The reason why silicon nitride powder having a β-phase transition rate of less than or equal to 20% is used is because both the strength and the value of fracture toughness can be increased. If silicon nitride powder having a β-phase transition rate of greater than 20% is used, due to nucleation in grain growth occurring in firing process, the resultant crystal will tend to have a coarse-grained texture with a smaller aspect ratio. This raises the possibility of a decline in both the strength and the value of fracture toughness. For this reason it is particularly desirable to use silicon nitride powder having a β-phase transition rate of less than or equal to 10%.

A ball used for the pulverization of powder of silicon nitride and additive components is preferably made of a material impervious to impurities or made of a silicon nitride sintered body of the same material composition as that of the powder. Note that, assuming that the cumulative total sum of powder volume based on a particle size distribution curve is 100%, then a particle size corresponding to a cumulative volume of 90% is defined as a particle size ($D_{90}$), and it is preferable that the powder of silicon nitride and additive components is pulverized until the particle size ($D_{90}$) reaches 3 $\mu$m or less from the standpoint of improvement in sinterability. The particle size distribution obtained as the result of pulverization can be controlled by adjusting the outer diameter of a ball, the amount of balls, the viscosity of the slurry, the time for pulverization, and so forth. Addition of a dispersant is desirable for a decrease in the slurry viscosity. In order to achieve pulverization in a short period of time, it is desirable to use powder having a particle size ($D_{50}$) of 1 $\mu$m or less.

Next, the slurry thusly obtained is sifted through a sieve with a mesh finer than Number 200 mesh defined in the standard ASTM E 11-61 with subsequent drying process, thereby preparing granules predominantly composed of silicon nitride (hereafter referred to as "silicon nitride granules"). The drying process can be conducted by means of a spray dryer or otherwise. Then, the silicon nitride granules are molded into sheet form by powder rolling to obtain a ceramic green sheet. The ceramic green sheet is cut in a predetermined length, thereby forming a molded product predominantly composed of silicon nitride (hereafter referred to as "silicon nitride molded product"). Instead of powder rolling, pressure molding may be used. In this case, the silicon nitride granules are charged into a mold with subsequent pressurization, thereby forming a silicon nitride molded product having the form of a rectangular column, a rectangular plate, a cylindrical column, or a disk, for example.

Next, a powdery body such as granules or a powder bed containing silicon is placed on a main surface of the silicon nitride molded product. The powdery body can be placed on the main surface of the silicon nitride molded product by sprinkling using a sieve. Alternatively, the powdery body is formed into a slurry with addition of a solvent, and the slurry can be applied to the main surface with a brush, a roller, or the like. For example, the powder constituting the powdery body includes at least one of silicon powder, silicon nitride powder, silicon oxide powder, and sialon powder, and, as additive components, one of magnesium oxide and calcium oxide (CaO), and powder of rare-earth oxide. For example, "granules" are prepared by a method involving a step of mixing powdery substances used in the production of the above-described powdery body, a step of pulverizing the mixture to form a slurry, and a step of drying the slurry by a spray dryer, and "powder bed" is prepared by pulverizing a sintered product obtained by firing powdery substances used in the production of the powdery body.

Next, a plurality of silicon nitride molded products each having the powdery body placed on its main surface are stacked on top of each other in layers inside a sagger made of sintered silicon nitride having a relative density in the range of 55% or above and 95% or below. In order to suppress volatilization of the components contained in the silicon nitride molded product, a common material containing magnesium oxide, rare-earth oxide, and the like component is placed around the layered molded product. Then, the layered molded product is fired in a firing furnace in which is disposed a graphite resistive heating element. Note that the amount of the common material preferably falls in the range of 2% or above and lower than 10% by mass with respect to the sum of the masses of the silicon nitride molded products.

Moreover, the firing temperature is elevated from ambient temperature to 300 to 1000°C in a vacuum atmosphere, and whereafter a nitrogen gas is introduced, and the partial pressure of nitrogen is maintained at 15 to 900 kPa. In this statue, the silicon nitride molded product exhibits an open porosity in a range of ca.40% to 55%, wherefore the nitrogen gas can be changed sufficiently in the silicon nitride molded product. In the vicinity of 1000 to 1400°C, the additive components undergo a solid-phase reaction to form a liquid-phase component. In a temperature range of 1400°C or above, an irreversible $\alpha$-to-$\beta$ phase transition takes place. Then, the internal temperature of the firing furnace is raised so that the temperature falls in the range of 1560°C or above and 1640°C or below, and this state is maintained for more than or equal to 2 hours but fewer than or equal to 4 hours, and whereafter the temperature is further raised so as to fall in the range of 1700°C or above and 1730°C or below, and this state is maintained for more than or equal to 4 hours but fewer than or equal to 10 hours. In this way, the component represented as $REMgSi_2O_5N$ (RE represents rare-earth metal) can be included in the grain boundary phase. Particularly, in order to ensure that the grain boundary phase includes, in addition to the component represented as $REMgSi_2O_5N$ (RE represents rare-earth metal), at least one of components that are expressed in compositional formula form as: $RE_2Si_3O_3N_4$, and $RE_4Si_2O_7N_2$ (or $RE_5Si_3O_{12}N$ in examples useful for understanding the invention) (RE represents rare-earth metal), respectively, it is advisable that a final temperature is adjusted to be higher than or equal to 1740°C but lower than 1800°C, and this state is maintained for more than or equal to 4 hours but fewer than or equal to 10 hours. After the lapse of the above temperature-holding period, cooling is effected at a rate of 20°C or above and 500°C or below per hour, thereby forming the ceramic sintered body of the embodiment. As will hereafter be described, by making changes to the per-hour cooling rate appropriately, it is possible to control the crystallizability of the component expressed in compositional formula form as:

$REMgSi_2O_5N$ (RE represents rare-earth metal), and thereby adjust its peak intensity and half width at a given diffraction angle determined by X-ray diffractometry.

That is, in order to ensure that the half width of the peak intensity $I_1$ at the diffraction angle of 30 to 31° in the component expressed in compositional formula form as:

REMgSi$_2$O$_5$N (RE represents rare-earth metal) that is determined by X-ray diffractometry is less than or equal to 0.4°, it is advisable that cooling is effected at a rate of 480°C or below per hour.

Moreover, in order to ensure that the ratio (I$_1$/I$_0$) is greater than or equal to 5.5%, where I$_0$ denotes the peak intensity at the diffraction angle of 27 to 28°in silicon nitride included in the main crystalline phase that is determined by X-ray diffractometry, it is advisable that cooling is effected at a rate of 460°C or below per hour.

According to examples useful for understanding the invention, in order to ensure that the product of relative permittivity and dielectric loss tangent at any given frequency in the range of 2 GHz to 3 GHz is less than or equal to 0.01 (exclusive of 0), it is advisable that the ceramic sintered body of the embodiment obtained by the method thus far described is subjected to heat treatment in a manner such that the temperature is adjusted to be higher than or equal to 1700°C but lower than 1730°C in a nitrogen atmosphere, and this state is maintained for more than or equal to 1 hour but fewer than or equal to 2 hours.

Next, a method for manufacturing the circuit board of the embodiment will be described.

The first step in obtaining the circuit board 10 exemplified in Fig. 1 is to prepare a support substrate 1 made of the ceramic sintered body of the embodiment, which falls in the range of 20 mm or more and 200 mm or less in length in the X direction, falls in the range of 10 mm or more and 120 mm or less in length in the Y direction, and falls in the range of 0.2 mm or more and 1.0 mm or less in thickness. Next, a brazing material in paste form made of a silver (Ag)-copper (Cu) alloy containing one or more of substances selected from among titanium, zirconium, hafnium, and niobium is coated on both main surfaces of the support substrate 1 by any one of screen printing, roll coater, brush coating, and the like. Then, on the first main surface are placed circuit members 2a and 2b predominantly composed of copper, and on the second main surface is placed a heat-dissipation member 3 predominantly composed of copper. The above-described pasty brazing material may contain one or more of substances selected from among molybdenum, tantalum, osmium, rhenium, and tungsten. After that, by the application of heat at a temperature in the range of 800°C or above and 900°C or below, and simultaneously, by the application of a pressure of greater than or equal to 30 MPa, it is possible to obtain the circuit board 10 in which the circuit members 2a and 2b are bonded to the first main surface of the support substrate 1, with the brazing material 4a interposed between them, and the heat-dissipation member 3 is bonded to the second main surface thereof, with the brazing material 4b interposed between them.

Moreover, in order to obtain the circuit board 10', 10" exemplified in Fig. 2, 3, firstly, a support substrate 1 having the above-described dimensions is prepared. Then, a pasty brazing material made of a silver-copper alloy containing one or more of substances selected from among titanium, zirconium, hafnium, and niobium is coated on both main surfaces of the support substrate 1 by any one of screen printing, roll coater, brush coating, and the like, and on the surfaces are placed thin copper materials 5a and 5b, respectively. The above-described pasty brazing material may contain one or more of substances selected from among molybdenum, tantalum, osmium, rhenium, and tungsten. After that, under the application of heat at a temperature in the range of 800°C or above and 900°C or below, the brazing material 4a and the copper material 5a are formed on the first main surface of the support substrate 1, and the brazing material 4b and the copper material 5b are formed on the second main surface thereof. After grinding that surface of the copper material 5a which faces the circuit members 2a and 2b, as well as that surface of the copper material 5b which faces the heat-dissipation member 3, the circuit member 2a, 2b and the heat-dissipation member 3 are placed on the copper material 5a and the copper material 5b, respectively. Then, in an atmosphere selected from among a hydrogen atmosphere, a nitrogen atmosphere, a neon atmosphere, and an argon atmosphere, by the application of heat at a temperature in the range of 300°C or above and 500°C or below, and simultaneously, by the application of a pressure of greater than or equal to 30 MPa, it is possible to obtain the circuit board 10 in which the circuit member 2 is bonded to the first main surface of the support substrate 1, with the brazing material 4a and the copper material 5a interposed one after another between them, and the heat-dissipation member 3 is bonded to the second main surface thereof, with the brazing material 4b and the copper material 5b interposed one after another between them.

Practical examples of the invention and examples useful for understanding the invention will be described hereinbelow.

Example 1

To begin with, powder of silicon nitride having a β-phase transition rate of 10% (in other words, an α-phase transition rate of 90%) and, as additive components, powder of magnesium oxide (MgO) and rare-earth oxide as listed in Table 1 have been mixed together by wet mixing using a tumbling mill. The resultant mixture has been pulverized until the particle size (D$_{90}$) became less than or equal to 1 μm, thereby forming a slurry.

Magnesium oxide and each of rare-earth oxides containing Er, Yb, and Y as listed in Table 1 were so added that the magnesium oxide is 3% by mass and the rare-earth oxide is 14% by mass in content with respect to 100% by mass of the ceramic sintered body. In examples useful for understanding the invention also rare-earth oxides not containing Er, Yb, or Y of Table 1 may be used.

Next, the resultant slurry has been sifted through a sieve with a Number 250 mesh defined in the standard ASTM E 11-61 with subsequent drying process using a spray dryer, thereby preparing silicon nitride granules. The silicon nitride granules have been molded into sheet form by powder rolling to obtain a ceramic green sheet. The ceramic green sheet was cut in a predetermined length, thereby forming a silicon nitride molded product.

Next, in the same manner as above described, there were prepared granules that include silicon nitride powder as a major constituent, and magnesium oxide powder and rare-earth oxide powder as listed in Table 1 that predominantly constitute the grain boundary phase as additive components. With use of a roller having a recess at its surface, the resultant granules were charged into the recess of the roller. The roller has been rotated on the main surface of the silicon nitride molded product of each test sample to set the granules on the main surface.

Next, a plurality of silicon nitride molded products with the granules placed on their main surfaces were stacked on top of each other in layers inside a sagger made of sintered silicon nitride having a relative density of 75% on a sample-by-sample basis. A common material containing such components as magnesium oxide and rare-earth oxide was placed around the silicon nitride molded products in an amount of 6% by mass with respect to the sum of the masses of the silicon nitride molded products. The structure in such a condition was put in a firing furnace in which is disposed a graphite resistive heating element for firing.

At this time, the temperature has been elevated from ambient temperature to 500°C in a vacuum atmosphere, and whereafter a nitrogen gas was introduced, and the partial pressure of nitrogen has been maintained at 100 kPa. Then, the internal temperature of the firing furnace was raised to 1580°C, and this state has been maintained for 4 hours, and whereafter the temperature was further raised to a temperature as listed in Table 1, and this state has been maintained for 6 hours. After that, cooling has been effected at a temperature-lowering rate as listed in Table 1, thereby forming samples Nos. 1 through 29 which are support substrates, the respective support substrates being made of the ceramic sintered body having a main crystalline phase predominantly composed of silicon nitride, and has a length of 60 mm, a width of 30 mm, and a thickness of 0.32 mm.

Magnesium oxide, rare-earth oxide, and each of components that are expressed in compositional formula form as:

$REMgSi_2O_5N$, $RE_2Si_3O_3N_4$, $RE_4Si_2O_7N_2$, and $RE_5Si_3O_{12}N$ (RE represents rare-earth metal), respectively, were identified by X-ray diffractometry, and their contents were determined by energy dispersive X-ray spectrometry. Table 1 shows the major component and contained components constituting the grain boundary phase.

Moreover, with use of X-ray diffraction equipment (X'PertPRO, manufactured by Spectris Co., Ltd.), measurement has been performed on the component represented as $REMgSi_2O_5N$ (RE represents rare-earth metal) contained in the crystal grain boundary of each test sample in respect of the first peak intensity $I_1$ and its half width at the diffraction angle of 30 to 31° according to X-ray diffractometry. In addition, measurement has been performed on silicon nitride contained in the main crystalline phase in respect of the first peak intensity $I_0$ at the diffraction angle of 27 to 28°. Then, the ratio ($I_1/I_0$) was obtained by calculation.

Further, the thermal diffusivity $\alpha$ of each test sample in its thickness-wise direction was measured by a two-dimensional method based on laser flash using a thermal constant measurement equipment (TC-7000, manufactured by ULVAC-RIKO, Inc.); the specific heat capacity C of each test sample was measured by the differential scanning calorimetry method (DSC method) using a supersensitive differential scanning calorimeter (DSC-6200, manufactured by Seiko Instruments, Inc.); and the bulk density p ($kg/m^3$) of each test sample was measured in conformity with JIS R 1634-1998. With substitution of the values obtained by the above-described manners into the following equation (1), the thermal conductivity $\kappa$ (W/(m·K)) of each test sample in its thickness-wise direction was determined by calculation.

$$\kappa = \alpha \cdot C \cdot \rho \qquad (1)$$

Moreover, the rigidity of each test sample was evaluated in terms of dynamic elasticity modulus. The dynamic elasticity modulus of each test sample was measured by the cantilever-based resonance method. The result of measurement is listed in Table 1.

Table 1

| Sample No. | Additive components | Temperature (°C) | Grain boundary phase | | | | | |
|---|---|---|---|---|---|---|---|---|
| | | | Major constituent | | Contained constituent | | | |
| 1 | $Sc_2O_3$ | 1730 | MgO | $Sc_2O_3$ | $ScMgSi_2O_5N$ | - | - | - |
| 2 | $Y_2O_3$ | 1690 | MgO | $Y_2O_3$ | - | - | - | - |
| 3 | $Y_2O_3$ | 1730 | MgO | $Y_2O_3$ | $YMgSi_2O_5N$ | - | - | - |
| 4 | $Y_2O_3$ | 1750 | MgO | $Y_2O_3$ | $YMgSi_2O_5N$ | $Y_2Si_3O_3N_4$ | - | - |
| 5 | $Y_2O_3$ | 1770 | MgO | $Y_2O_3$ | $YMgSi_2O_5N$ | $Y_2Si_3O_3N_4$ | $Y_4Si_2O_7N_2$ | - |
| 6 | $Y_2O_3$ | 1790 | MgO | $Y_2O_3$ | $YMgSi_2O_5N$ | $Y_2Si_3O_3N_4$ | $Y_4Si_2O_7N_2$ | $Y_5Si_3O_{12}N$ |
| 7 | $La_2O_3$ | 1730 | MgO | $La_2O_3$ | $LaMgSi_2O_5N$ | - | - | - |
| 8 | $Ce_2O_3$ | 1730 | MgO | $Ce_2O_3$ | $CeMgSi_2O_5N$ | - | - | - |
| 9 | $Pr_6O_{11}$ | 1730 | MgO | $Pr_6O_{11}$ | $PrMgSi_2O_5N$ | - | - | - |
| 10 | $Nd_2O_3$ | 1730 | MgO | $Nd_2O_3$ | $NdMgSi_2O_5N$ | - | - | - |
| 11 | $Pm_2O_3$ | 1730 | MgO | $Pm_2O_3$ | $PmMgSi_2O_5N$ | - | - | - |
| 12 | $Sm_2O_3$ | 1730 | MgO | $Sm_2O_3$ | $SmMgSi_2O_5N$ | - | - | - |
| 13 | $Eu_2O_3$ | 1730 | MgO | $Eu_2O_3$ | $EuMgSi_2O_5N$ | - | - | - |
| 14 | $Gd_2O_3$ | 1730 | MgO | $Gd_2O_3$ | $GdMgSi_2O_5N$ | - | - | - |
| 15 | $Tb_2O_3$ | 1730 | MgO | $Tb_2O_3$ | $TbMgSi_2O_5N$ | - | - | - |
| 16 | $Dy_2O_3$ | 1730 | MgO | $Dy_2O_3$ | $DyMgSi_2O_5N$ | - | - | - |
| 17 | $Ho_2O_3$ | 1730 | MgO | $Ho_2O_3$ | $HoMgSi_2O_5N$ | - | - | - |
| 18 | $Er_2O_3$ | 1690 | MgO | $Er_2O_3$ | - | - | - | - |
| 19 | $Er_2O_3$ | 1720 | MgO | $Er_2O_3$ | $ErMgSi_2O_5N$ | - | - | - |
| 20 | $Er_2O_3$ | 1740 | MgO | $Er_2O_3$ | $ErMgSi_2O_5N$ | $Er_2Si_3O_3N_4$ | - | - |
| 21 | $Er_2O_3$ | 1760 | MgO | $Er_2O_3$ | $ErMgSi_2O_5N$ | $Er_2Si_3O_3N_4$ | $Er_4Si_2O_7N_2$ | - |
| 22 | $Er_2O_3$ | 1780 | MgO | $Er_2O_3$ | $ErMgSi_2O_5N$ | $Er_2Si_3O_3N_4$ | $Er_4Si_2O_7N_2$ | $Er_5Si_3O_{12}N$ |

Table 1 (Continued)

| Sample No. | Temperature-lowering rate (°C/time) | Half width (°) | Ratio ($I_1/I_0$) (%) | Thermal conductivity κ (W/(m·K)) | Dynamic elasticity modulus (GPa) |
|---|---|---|---|---|---|
| 1 | 500 | 0.42 | 5.4 | 55 | 304 |
| 2 | 500 | - | - | 52 | 296 |
| 3 | 500 | 0.42 | 5.4 | 57 | 305 |
| 4 | 500 | 0.41 | 5.4 | 58 | 307 |
| 5 | 500 | 0.41 | 5.4 | 59 | 310 |
| 6 | 500 | 0.41 | 5.4 | 60 | 312 |
| 7 | 500 | 0.42 | 5.4 | 56 | 305 |
| 8 | 500 | 0.42 | 5.4 | 56 | 305 |
| 9 | 500 | 0.42 | 5.4 | 56 | 305 |
| 10 | 500 | 0.42 | 5.4 | 55 | 305 |
| 11 | 500 | 0.42 | 5.4 | 55 | 305 |
| 12 | 500 | 0.42 | 5.4 | 55 | 305 |
| 13 | 500 | 0.42 | 5.4 | 55 | 305 |
| 14 | 500 | 0.42 | 5.4 | 55 | 305 |
| 15 | 500 | 0.42 | 5.4 | 55 | 305 |
| 16 | 500 | 0.42 | 5.4 | 55 | 305 |
| 17 | 500 | 0.42 | 5.4 | 55 | 305 |
| 18 | 500 | - | - | 52 | 297 |
| 19 | 500 | 0.42 | 5.4 | 57 | 306 |
| 20 | 500 | 0.41 | 5.4 | 58 | 308 |
| 21 | 500 | 0.41 | 5.4 | 59 | 309 |
| 22 | 500 | 0.41 | 5.4 | 60 | 312 |

EP 2 546 216 B1

Table 1 (Continued)

| Sample No. | Additive components | Temperature (°C) | Grain boundary phase | | | | |
|---|---|---|---|---|---|---|---|
| | | | Major constituent | | Contained constituent | | |
| 23 | $Tm_2O_3$ | 1730 | MgO | $Tm_2O_3$ | $TmMgSi_2O_5N$ | - | - | - |
| 24 | $Yb_2O_3$ | 1690 | MgO | $Yb_2O_3$ | - | - | - | - |
| 25 | $Yb_2O_3$ | 1730 | MgO | $Yb_2O_3$ | $YbMgSi_2O_5N$ | - | - | - |
| 26 | $Yb_2O_3$ | 1750 | MgO | $Yb_2O_3$ | $YbMgSi_2O_5N$ | $Yb_2Si_3O_3N_4$ | - | - |
| 27 | $Yb_2O_3$ | 1770 | MgO | $Yb_2O_3$ | $YbMgSi_2O_5N$ | $Yb_2Si_3O_3N_4$ | $Yb_4Si_2O_7N_2$ | - |
| 28 | $Yb_2O_3$ | 1790 | MgO | $Yb_2O_3$ | $YbMgSi_2O_5N$ | $Yb_2Si_3O_3N_4$ | $Yb_4Si_2O_7N_2$ | $Yb_5Si_3O_{12}N$ |
| 29 | $Lu_2O_3$ | 1730 | MgO | $Lu_2O_3$ | $LuMgSi_2O_5N$ | - | - | - |
| 30 | $Y_2O_3$ | 1730 | MgO | $Y_2O_3$ | $YMgSi_2O_5N$ | - | - | - |
| 31 | $Y_2O_3$ | 1730 | MgO | $Y_2O_3$ | $YMgSi_2O_5N$ | - | - | - |
| 32 | $Y_2O_3$ | 1730 | MgO | $Y_2O_3$ | $YMgSi_2O_5N$ | - | - | - |
| 33 | $Er_2O_3$ | 1720 | MgO | $Er_2O_3$ | $ErMgSi_2O_5N$ | - | - | - |
| 34 | $Er_2O_3$ | 1720 | MgO | $Er_2O_3$ | $ErMgSi_2O_5N$ | - | - | - |
| 35 | $Er_2O_3$ | 1720 | MgO | $Er_2O_3$ | $ErMgSi_2O_5N$ | - | - | - |
| 36 | $Yb_2O_3$ | 1730 | MgO | $Yb_2O_3$ | $YbMgSi_2O_5N$ | - | - | - |
| 37 | $Yb_2O_3$ | 1730 | MgO | $Yb_2O_3$ | $YbMgSi_2O_5N$ | - | - | - |
| 38 | $Yb_2O_3$ | 1730 | MgO | $Yb_2O_3$ | $YbMgSi_2O_5N$ | - | - | - |

Table 1 (Continued)

| Sample No. | Temperature-lowering rate (°C/time) | Half width (°) | Ratio (I₁/I₀) (%) | Thermal conductivity κ (W/(m·K)) | Dynamic elasticity modulus (GPa) |
|---|---|---|---|---|---|
| 23 | 500 | 0.42 | 5.4 | 55 | 305 |
| 24 | 500 | - | - | 52 | 297 |
| 25 | 500 | 0.42 | 5.4 | 57 | 306 |
| 26 | 500 | 0.41 | 5.4 | 58 | 308 |
| 27 | 500 | 0.41 | 5.4 | 59 | 309 |
| 28 | 500 | 0.41 | 5.4 | 60 | 312 |
| 29 | 500 | 0.42 | 5.4 | 55 | 305 |
| 30 | 480 | 0.40 | 5.4 | 58 | 308 |
| 31 | 460 | 0.39 | 5.5 | 63 | 311 |
| 32 | 440 | 0.39 | 5.6 | 65 | 312 |
| 33 | 480 | 0.40 | 5.4 | 58 | 308 |
| 34 | 460 | 0.39 | 5.5 | 63 | 309 |
| 35 | 440 | 0.39 | 5.6 | 65 | 312 |
| 36 | 480 | 0.40 | 5.4 | 58 | 308 |
| 37 | 460 | 0.39 | 5.5 | 63 | 309 |
| 38 | 440 | 0.39 | 5.6 | 65 | 311 |

As shown in Table 1, Sample Nos. 1, 3 through 17, 19 through 23, and 25 through 29, having the component expressed in compositional formula form as: $REMgSi_2O_5N$ (RE represents rare-earth metal) in its grain boundary phase, are higher in both thermal conductivity and dynamic elasticity modulus than Sample Nos. 2, 18, and 24 having no $REMgSi_2O_5N$ in its grain boundary phase. It has thus been found out that the use of Sample Nos. 1, 3 through 17, 19 through 23, and 25 through 29 for the support substrate 1 which constitutes the circuit board 10 shown in Fig. 1 makes it possible to obtain a highly-reliable circuit board which is resistant to cracking.

Moreover, in each of Sample Nos. 30 through 38 that have been cooled down at a temperature-lowering rate of 480°C or below, the half width of the peak intensity $I_1$ in the component expressed in compositional formula form as: $REMgSi_2O_5N$ (RE represents rare-earth metal) contained in the grain boundary phase was less than or equal to 0.4°. As the result of comparison between Sample Nos. 30 through 32 and Sample No. 3, comparison between Sample Nos. 33 through 35 and Sample No. 19, and comparison between Sample Nos. 36 through 38 and Sample No. 25, then a tendency was found out that Sample Nos. 30 through 38 are higher in both thermal conductivity and dynamic elasticity modulus than Sample Nos. 3, 19, and 25 in which the half width of the peak intensity $I_1$ is greater than 0.4°.

Further, in each of Sample Nos. 31, 32, 34, 35, 37, and 38 that have been cooled down at a temperature-lowering rate of 460°C or below, the ratio $(I_1/I_0)$ was 5.5% or above, and a tendency was found out that Sample Nos. 31, 32, 34, 35, 37, and 38 are higher in both thermal conductivity and dynamic elasticity modulus than Sample Nos. 30, 33, and 36 in which the ratio $(I_1/I_0)$ is less than 5.5%.

In addition, each of Sample Nos. 4 through 6, 20 through 22, and 26 through 28 in which the grain boundary phase includes, in addition to $REMgSi_2O_5N$, at least one of components that are expressed in compositional formula form as: $RE_2Si_3O_3N_4$, $RE_4Si_2O_7N_2$, and $RE_5Si_3O_{12}N$ (RE represents rare-earth metal), respectively, was found to exhibit even higher thermal conductivity and even higher dynamic elasticity modulus.

Example 2

To begin with, powder of silicon nitride having a β-phase transition rate of 10% (in other words, an α-phase transition rate of 90%) and, as additive components, powder of magnesium oxide and rare-earth oxide containing Er, Yb, or Y as listed in Table 1 have been mixed together by wet mixing using a tumbling mill. The resultant mixture has been pulverized until the particle size ($D_{90}$) became less than or equal to 1 μm, thereby forming a slurry. In examples useful for understanding the invention also rare-earth oxides not containing Er, Yb, or Y of Table 1 may be used.

Magnesium oxide and each of rare-earth oxides as listed in Table 1 were so added that the magnesium oxide is 3% by mass and the rare-earth oxide is 14% by mass in content with respect to 100% by mass of the ceramic sintered body.

Next, the resultant slurry has been sifted through a sieve with a Number 250 mesh defined in the standard ASTM E 11-61 with subsequent drying process using a spray dryer, thereby preparing silicon nitride granules. The silicon nitride granules have been molded into sheet form by powder rolling to obtain a ceramic green sheet. The ceramic green sheet was punched into the disk shape, thereby forming a silicon nitride molded product.

From then on, in the same procedure as adopted in Example 1, a ceramic sintered body was obtained. The ceramic sintered body of this example is predominantly composed of silicon nitride, and has the form of a disk which is 48 mm in diameter and 1 mm in thickness. At this time, the temperature-lowering rate was set at 500°C/hour. In this way, Sample Nos. 39 through 47 were obtained.

It is noted that the ceramic sintered bodies of Sample Nos. 40, 41, 43, 44, 46, and 47 have been heat-treated in accordance with the temperatures and temperature-holding periods as listed in Table 2.

Then, the relative permittivity and the dielectric loss tangent of each test sample at 2 GHz, as well as at 3 GHz, have been measured by a dielectric loaded-cavity resonance method. More specifically, measurement has been performed on each sample in the form of being sandwiched between the parts of a centrally-divided cylindrical cavity resonator in respect of relative permittivity, dielectric loss tangent, and the product of them on the basis of TE011 mode resonant characteristics, and the calculated values are listed in Table 2.

Table 2

| Sample No. | Additive components | Temperature (°C) | Grain boundary phase | | Heat treatment | |
|---|---|---|---|---|---|---|
| | | | Major constituent | Contained constituent | Temperature (°C) | Temperature-holding period (Hour) |
| 39 | $Y_2O_3$ | 1730 | MgO $Y_2O_3$ | $YMgSi_2O_5N$ | - | - |
| 40 | $Y_2O_3$ | 1730 | MgO $Y_2O_3$ | $YMgSi_2O_5N$ | 1700 | 1 |
| 41 | $Y_2O_3$ | 1730 | MgO $Y_2O_3$ | $YMgSi_2O_5N$ | 1720 | 2 |
| 42 | $Er_2O_3$ | 1720 | MgO $Er_2O_3$ | $ErMgSi_2O_5N$ | - | - |
| 43 | $Er_2O_3$ | 1720 | MgO $Er_2O_3$ | $ErMgSi_2O_5N$ | 1700 | 1 |
| 44 | $Er_2O_3$ | 1720 | MgO $Er_2O_3$ | $ErMgSi_2O_5N$ | 1720 | 2 |
| 45 | $Yb_2O_3$ | 1730 | MgO $Yb_2O_3$ | $YbMgSi_2O_5N$ | - | - |
| 46 | $Yb_2O_3$ | 1730 | MgO $Yb_2O_3$ | $YbMgSi_2O_5N$ | 1700 | 1 |
| 47 | $Yb_2O_3$ | 1730 | MgO $Yb_2O_3$ | $YbMgSi_2O_5N$ | 1720 | 2 |

Table 2 (Continued)

| Sample No. | Frequency (2 GHz) | | | Frequency (3 GHz) | | |
|---|---|---|---|---|---|---|
| | Relative permittivity | Dielectric loss tangent | Product | Relative permittivity | Dielectric loss tangent | Product |
| 39 | 8.41 | 0.0014 | 0.012 | 8.35 | 0.0013 | 0.011 |
| 40 | 8.41 | 0.00102 | 0.009 | 8.35 | 0.00119 | 0.01 |
| 41 | 8.40 | 0.00101 | 0.008 | 8.34 | 0.00114 | 0.01 |
| 42 | 8.41 | 0.0013 | 0.011 | 8.35 | 0.0013 | 0.011 |
| 43 | 8.41 | 0.00101 | 0.008 | 8.35 | 0.00119 | 0.01 |
| 44 | 8.40 | 0.00101 | 0.008 | 8.33 | 0.00114 | 0.01 |
| 45 | 8.41 | 0.0014 | 0.012 | 8.35 | 0.0013 | 0.011 |
| 46 | 8.41 | 0.00102 | 0.009 | 8.35 | 0.00119 | 0.01 |
| 47 | 8.40 | 0.00101 | 0.008 | 8.34 | 0.00114 | 0.01 |

As will be understood from the result of measurement as listed in Table 2, in Sample Nos. 40, 41, 43, 44, 46, and 47, since the product of relative permittivity and dielectric loss tangent at any given frequency in the range of 2 GHz to 3 GHz is 0.01 or less (exclusive of 0), even if a microwave propagates through the interior of the ceramic sintered body at frequencies in the range of 2 GHz to 3 GHz, the microwave is less prone to attenuation. Accordingly, the above samples can be desirably applied to various structural components mounted inside plasma treatment equipment, such as a microwave transmission window member of plasma treatment equipment, as well as to substrates for signal transfer in a microwave region.

Example 3

To begin with, powder of silicon nitride having a β-phase transition rate of 10% (in other words, an α-phase transition rate of 90%) and, as additive components, magnesium oxide powder and rare-earth oxide powder have been mixed together by wet mixing using a tumbling mill. The resultant mixture has been pulverized until the particle size ($D_{90}$) became less than or equal to 1 $\mu$m, thereby forming a slurry.

The additive components were so added that their contents with respect to the ceramic sintered body take on the values as listed in Table 3.

Next, the resultant slurry has been sifted through a sieve with a Number 250 mesh defined in the standard ASTM E 11-61 with subsequent drying process using a spray dryer, thereby preparing silicon nitride granules. Then, with pressure molding, the silicon nitride granules were charged into a mold with subsequent pressurization, thereby forming silicon nitride molded products having the forms of a rectangular column and a disk.

Next, in the same manner as above described, there were prepared granules that include silicon nitride powder as a major constituent, and magnesium oxide powder and rare-earth oxide powder as listed in Table 3 that predominantly constitute the grain boundary phase as additive components. With use of a roller having a recess at its surface, the resultant granules were charged into the recess of the roller. The roller has been rotated on the main surface of the silicon nitride molded product of each test sample to set the granules on the main surface of the silicon nitride molded product of each test sample.

Next, a plurality of silicon nitride molded products with the granules placed on their main surfaces were stacked on top of each other in layers inside a sagger made of sintered silicon nitride having a relative density of 80% on a sample-by-sample basis. A common material containing such components as magnesium oxide and rare-earth oxide was placed around the silicon nitride molded products in an amount of 6% by mass with respect to the sum of the masses of the silicon nitride molded products. The structure in such a condition was put in a firing furnace in which is disposed a graphite resistive heating element for firing.

At this time, the temperature has been elevated from ambient temperature to 500°C in a vacuum atmosphere, and whereafter a nitrogen gas was introduced, and the partial pressure of nitrogen has been maintained at 100 kPa. Then, the internal temperature of the firing furnace was raised to 1580°C, and this state has been maintained for 4 hours, and whereafter the temperature was further raised to 1770°C, and this state has been maintained for 6 hours. In this way, there were obtained test samples numbered 39 through 68 made of the ceramic sintered body predominantly composed of silicon nitride, which have the forms of a rectangular column and a disk.

Magnesium oxide, rare-earth oxide, and each of the components that are expressed in compositional formula form as: $REMgSi_2O_5N$, $RE_2Si_3O_3N_4$, and $RE_4Si_2O_7N_2$ (RE represents rare-earth metal), respectively, were identified by X-ray diffractometry, and their contents were determined by energy dispersive X-ray spectrometry. Table 3 shows the major constituent of the grain boundary phase and its content, and other components contained therein.

Moreover, the thermal conductivity $\kappa$ (W/(m·K)) of each test sample in its thickness-wise direction was determined, with use of a disk-shaped sample, in the same manner as adopted in Example 1. Further, the three-point bending strength of each test sample was determined, with use of a rectangular-columnar-shaped sample, in conformity with JIS R 1601-2008 (ISO 17565: 2003 (MOD)). The values thusly obtained are listed in Table 3.

Table 3

| Sample No. | Grain boundary phase | | | | | | | Thermal conductivity κ (W/(m·K)) | Three-point bending strength (MPa) |
| --- | --- | --- | --- | --- | --- | --- | --- | --- | --- |
| | Major constituent | | | | Contained constituent | | | | |
| | Compositional formula | Content (mass%) | Compositional formula | Content (mass%) | Compositional formula | Compositional formula | Compositional formula | | |
| 39 | MgO | 0.5 | $Er_2O_3$ | 13 | $ErMgSi_2O_5N$ | $Er_2Si_3O_3N_4$ | $Er_4Si_2O_7N$ | 54 | 764 |
| 40 | MgO | 1.3 | $Er_2O_3$ | 13 | $ErMgSi_2O_5N$ | $Er_2Si_3O_3N_4$ | $Er_4Si_2O_7N$ | 59 | 802 |
| 41 | MgO | 3 | $Er_2O_3$ | 9 | $ErMgSi_2O_5N$ | $Er_2Si_3O_3N_4$ | $Er_4Si_2O_7N$ | 54 | 808 |
| 42 | MgO | 3 | $Er_2O_3$ | 10 | $ErMgSi_2O_5N$ | $Er_2Si_3O_3N_4$ | $Er_4Si_2O_7N$ | 58 | 815 |
| 43 | MgO | 3 | $Er_2O_3$ | 13 | $ErMgSi_2O_5N$ | $Er_2Si_3O_3N_4$ | $Er_4Si_2O_7N$ | 59 | 820 |
| 44 | MgO | 3 | $Er_2O_3$ | 15 | $ErMgSi_2O_5N$ | $Er_2Si_3O_3N_4$ | $Er_4Si_2O_7N$ | 59 | 815 |
| 45 | MgO | 3 | $Er_2O_3$ | 17 | $ErMgSi_2O_5N$ | $Er_2Si_3O_3N_4$ | $Er_4Si_2O_7N$ | 58 | 817 |
| 46 | MgO | 3 | $Er_2O_3$ | 18 | $ErMgSi_2O_5N$ | $Er_2Si_3O_3N_4$ | $Er_4Si_2O_7N$ | 54 | 820 |
| 47 | MgO | 5 | $Er_2O_3$ | 13 | $ErMgSi_2O_5N$ | $Er_2Si_3O_3N_4$ | $Er_4Si_2O_7N$ | 59 | 823 |
| 48 | MgO | 6 | $Er_2O_3$ | 13 | $ErMgSi_2O_5N$ | $Er_2Si_3O_3N4$ | $Er_4Si_2O_7N$ | 54 | 825 |
| 49 | MgO | 0.5 | $Yb_2O_3$ | 13 | $YbMgSi_2O_5N$ | $Yb_2Si_3O_3N_4$ | $Yb_4Si_2O_7N$ | 53 | 762 |
| 50 | MgO | 1.3 | $Yb_2O_3$ | 13 | $YbMgSi_2O_5N$ | $Yb_2Si_3O_3N_4$ | $Yb_4Si_2O_7N$ | 58 | 801 |
| 51 | MgO | 3 | $Yb_2O_3$ | 9 | $YbMgSi_2O_5N$ | $Yb_2Si_3O_3N_4$ | $Yb_4Si_2O_7N$ | 53 | 807 |
| 52 | MgO | 3 | $Yb_2O_3$ | 10 | $YbMgSi_2O_5N$ | $Yb_2Si_3O_3N_4$ | $Yb_4Si_2O_7N$ | 57 | 813 |
| 53 | MgO | 3 | $Yb_2O_3$ | 13 | $YbMgSi_2O_5N$ | $Yb_2Si_3O_3N_4$ | $Yb_4Si_2O_7N$ | 58 | 819 |
| 54 | MgO | 3 | $Yb_2O_3$ | 15 | $YbMgSi_2O_5N$ | $Yb_2Si_3O_3N_4$ | $Yb_4Si_2O_7N$ | 58 | 813 |
| 55 | MgO | 3 | $Yb_2O_3$ | 17 | $YbMgSi_2O_5N$ | $Yb_2Si_3O_3N_4$ | $Yb_4Si_2O_7N$ | 57 | 817 |
| 56 | MgO | 3 | $Yb_2O_3$ | 18 | $YbMgSi_2O_5N$ | $Yb_2Si_3O_3N_4$ | $Yb_4Si_2O_7N$ | 52 | 819 |
| 57 | MgO | 5 | $Yb_2O_3$ | 13 | $YbMgSi_2O_5N$ | $Yb_2Si_3O9_3Na$ | $Yb_4Si_2O_7N$ | 57 | 821 |
| 58 | MgO | 6 | $Yb_2O_3$ | 13 | $YbMgSi_2O_5N$ | $Yb_2Si_3O_3N_4$ | $Yb_4Si_2O_7N$ | 52 | 823 |
| 59 | MgO | 0.5 | $Y_2O_3$ | 13 | $YMgSi_2O_5N$ | $Y_2Si_3O_3N_4$ | $Y_4Si_2O_7N$ | 53 | 752 |
| 60 | MgO | 1.3 | $Y_2O_3$ | 13 | $YMgSi_2O_5N$ | $Y_2Si_3O_3N_4$ | $Y_4Si_2O_7N$ | 58 | 801 |
| 61 | MgO | 3 | $Y_2O_3$ | 9 | $YMgSi_2O_5N$ | $Y_2Si_3O_3N_4$ | $Y_4Si_2O_7N$ | 53 | 807 |

(continued)

| Sample No. | Grain boundary phase | | | | | | | Thermal conductivity $\kappa$ (W/(m·K)) | Three-point bending strength (MPa) |
|---|---|---|---|---|---|---|---|---|---|
| | Major constituent | | | | Contained constituent | | | | |
| | Compositional formula | Content (mass%) | Compositional formula | Content (mass%) | Compositional formula | Compositional formula | Compositional formula | | |
| 62 | MgO | 3 | $Y_2O_3$ | 10 | $YMgSi_2O_5N$ | $Y_2Si_3O_3N_4$ | $Y_4Si_2O_7N$ | 57 | 813 |
| 63 | MgO | 3 | $Y_2O_3$ | 13 | $YMgSi_2O_5N$ | $Y_2Si_3O_3N_4$ | $Y_4Si_2O_7N$ | 58 | 818 |
| 64 | MgO | 3 | $Y_2O_3$ | 15 | $YMgSi_2O_5N$ | $Y_2Si_3O_3N_4$ | $Y_4Si_2O_7N$ | 58 | 813 |
| 65 | MgO | 3 | $Y_2O3$ | 17 | $YMgSi_2O_5N$ | $Y_2Si_3O_3N_4$ | $Y_4Si_2O_7N$ | 57 | 817 |
| 66 | MgO | 3 | $Y_2O_3$ | 18 | $YMgSi_2O_5N$ | $Y_2Si_3O_3N_4$ | $Y_4Si_2O_7N$ | 52 | 818 |
| 67 | MgO | 5 | $Y_2O_3$ | 13 | $YMgSi_2O_5N$ | $Y_2Si_3O_3N_4$ | $Y_4Si_2O_7N$ | 57 | 821 |
| 68 | MgO | 6 | $Y_2O_3$ | 13 | $YMgSi_2O_5N$ | $Y_2Si_3O_3N_4$ | $Y_4Si_2O_7N$ | 52 | 822 |

As shown in Table 3, Sample Nos. 40, 42 through 45, 47, 50, 52 through 55, 57, 60, 62 through 65, and 67, having a magnesium oxide content of greater than or equal to 1.3% by mass but less than or equal to 5% by mass, and a rare-earth oxide content of greater than or equal to 10% by mass but less than or equal to 17% by mass, were found to exhibit higher thermal conductivity and higher three-point bending strength than Sample Nos. 39, 41, 46, 48, 49, 51, 56, 58, 59, 61, 66, and 68, which are examples useful for further understanding the invention.

It has thus been found out that, in the case where the magnesium oxide falls in the range of 1.3% or above by mass and 5% or below by mass and the rare-earth oxide falls in the range of 10% or above by mass and 17% or below by mass in content with respect to 100% by mass of the ceramic sintered body, further improvement in both heat-dissipation characteristics and mechanical characteristics can be achieved.

Reference Signs List

| 1, 1X, 1y: | Ceramic sintered body (Support substrate) |
| 2, 2a, 2b: | Circuit member |
| 3: | Heat-dissipation member |
| 4a, 4b: | Brazing material |
| 5a, 5b: | Copper material |
| 6, 7: | Electronic component |
| 10, 10', 10": | Circuit board |
| 20: | Thermoelectric conversion module |
| S: | Electronic device |

**Claims**

1. A ceramic sintered body (1, 1x, 1y), comprising:

    a main crystalline phase predominantly composed of silicon nitride; and
    a grain boundary phase predominantly composed of magnesium oxide and rare-earth oxide,
    the grain boundary phase containing components which are expressed in compositional formula form as: $REMgSi_2O_5N$, $RE_2Si_3O_3N_4$, and $RE_4Si_2O_7N$, respectively, where RE represents rare-earth metal which is Er, Yb or Y,
    the grain boundary phase having a magnesium oxide content of greater than or equal to 1.3% by mass and less than or equal to 5% by mass, and having a rare-earth oxide content of greater than or equal to 10% by mass and less than or equal to 17% by mass.

2. A circuit board (10, 10', 10"), comprising:

    a support substrate (1) formed of the ceramic sintered body according to claim 1;
    a circuit member (2, 2a, 2b) mounted on a first main surface of the support substrate (1); and
    a heat-dissipation member (3) mounted on a second main surface of the support substrate (1) opposite from the first main surface.

3. An electronic device (S), comprising:

    the circuit board (10, 10', 10") according to claim 2; and
    an electronic component (6, 7) mounted on the circuit member (2, 2a, 2b) of the circuit board (10, 10', 10").

4. A thermoelectric conversion module (20), comprising:

    the support substrate (1, 1x, 1y) formed of the ceramic sintered body according to claim 1; and
    a thermoelectric conversion device composed of a p-type thermoelectric conversion element and an n-type thermoelectric conversion element,
    the thermoelectric conversion device being electrically connected and bonded to the support substrate (1, 1x, 1y).

**Patentansprüche**

1. Keramischer gesinterter Körper (1, 1x, 1y) mit:

   einer kristallinen Hauptphase, die hauptsächlich Siliziumnitrid enthält; und
   einer Korngrenzenphase, die hauptsächlich Magnesiumoxid und einem Selten-Erdoxid enthält, wobei
   die Korngrenzenphase Komponenten enthält, die in einer Zusammensetzungsformel ausgedrückt werden als:
   $REMgSi_2O_5N$, $RE_2Si_3O_3N_4$ beziehungsweise $RE_4Si_2O_7N$, wobei RE ein Selten-Erdmetall repräsentiert, das Er, Yb oder Y ist,
   die Korngrenzenphase einen Magnesiumoxidgehalt, der größer oder gleich 1,3 % in der Masse und kleiner oder gleich 5 % in der Masse ist, und einen Selten-Erdoxidgehalt, der größer oder gleich 10 % in der Masse und kleiner oder gleich 17 % in der Masse ist, aufweist.

2. Schaltplatte (10, 10', 10") mit:

   einem Stützsubstrat (1), das auf dem keramischen gesinterten Körper nach Anspruch 1 gebildet ist;
   einem Schaltbauteil (2, 2a, 2b), das auf einer ersten Hauptfläche des Stützsubstrats (1) montiert ist; und
   einem Wärmedissipationsbauteil (3), das auf einer zweiten Hauptoberfläche des Stützsubstrats (1) gegenüber der ersten Hauptoberfläche montiert ist.

3. Elektronische Einrichtung (S) mit:

   der Schaltplatte (10, 10', 10") nach Anspruch 2; und
   einer elektronischen Komponente (6, 7), die auf dem Schaltbauteil (2, 2a, 2b) der Schaltplatte (10, 10', 10") montiert ist.

4. Thermoelektrisches Umwandlungsmodul (20) mit:

   dem Stützsubstrat (1, 1x, 1y), das auf dem keramischen gesinterten Körper nach Anspruch 1 gebildet ist; und
   einer thermoelektrischen Umwandlungseinrichtung, die aus einem thermoelektrischen Umwandlungselement des p-Typs und einem thermoelektrischen Umwandlungselement des n-Typs zusammengesetzt ist, wobei die thermoelektrische Umwandlungseinrichtung mit dem Stützsubstrat (1, 1x, 1y) elektrisch verbunden und an das Stützsubstrat gebunden ist.

**Revendications**

1. Corps fritté en céramique (1, 1x, 1y), comprenant :

   une phase cristalline principale, composée principalement de nitrure de silicium ; et
   une phase de joint de grains, composée principalement d'oxyde de magnésium et d'oxyde de terre rare,
   la phase de joint de grains contenant des composants qui sont exprimés sous la forme d'une formule de composition suivante : $REMgSi_2O_5N$, $RE_2Si_3O_3N_4$, et $RE_4Si_2O_7N$, respectivement, où RE représente un métal de terre rare qui est Er, Yb ou Y,
   la phase de joint de grains ayant une teneur en oxyde de magnésium supérieure ou égale à 1,3 % en poids et inférieure ou égale à 5 % en poids, et ayant une teneur en oxyde de terre rare supérieure ou égale à 10 % en poids et inférieure ou égale à 17 % en poids.

2. Carte de circuit imprimé (10, 10', 10"), comprenant :

   un substrat de support (1) formé du corps fritté en céramique selon la revendication 1 ;
   un élément de circuit (2, 2a, 2b) monté sur une première surface principale du substrat de support (1) ; et
   un élément de dissipation thermique (3) monté sur une seconde surface principale du substrat de support (1), opposée à la première surface principale.

3. Dispositif électronique (S), comprenant :

   la carte de circuit imprimé (10, 10', 10") selon la revendication 2 ; et

un composant électronique (6, 7) monté sur l'élément de circuit (2, 2a, 2b) de la carte de circuit imprimé (10, 10', 10").

4. Module de conversion thermoélectrique (20), comprenant :

le substrat de support (1, 1x, 1y) formé du corps fritté en céramique selon la revendication 1 ; et
un dispositif de conversion thermoélectrique constitué d'un élément de conversion thermoélectrique de type p et d'un élément de conversion thermoélectrique de type n,
le dispositif de conversion thermoélectrique étant raccordé et relié électriquement au substrat de support (1, 1x, 1y).

# FIG. 1

(a)

(b)

(c)

# FIG. 2

(a)

(b)

(c)

# FIG. 3

(a)

(b)

(c)

# FIG. 4

(a)

(b)

(c)

# FIG. 5

(a)

(b)

**EP 2 546 216 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008114752 A1
- JP 2009298688 A
- JP 2000034172 A